# EUROPÄISCHE PATENTSCHRIFT

(11) **EP 2 132 789 B1**
(45) Veröffentlichungstag und Bekanntmachung des Hinweises auf die Patenterteilung: **10.11.2010**
(21) Anmeldenummer: 08734436.2
(22) Anmeldetag: 26.03.2008
(51) Int. Cl.: H01L 33/00, H01L 25/075

(54) **ELEKTROMAGNETISCHE STRAHLUNG EMITTIERENDES OPTOELEKTRONISCHES BAUELEMENT UND VERFAHREN ZUR HERSTELLUNG EINES OPTOELEKTRONISCHEN BAUELEMENTS**
OPTOELECTRONICAL COMPONENT EMITTING ELECTROMAGNETIC RADIATION AND METHOD FOR PRODUCING AN OPTOELECTRONICAL COMPONENT
COMPOSANT OPTO-ELECTRONIQUE EMETTANT UN RAYONNEMENT ELECTROMAGNETIQUE ET PROCEDE DE FABRICATION D'UN COMPOSANT OPTO-ELECTRONIQUE

(30) Priorität: 30.03.2007 DE 102007015474
(43) Veröffentlichungstag der Anmeldung: 16.12.2009
(73) Patentinhaber: OSRAM Opto Semiconductors GmbH, 93055 Regensburg (DE)
(72) Erfinder: ARNDT, Karlheinz, 93077 Bad Abbach (DE); PETERSEN, Kirstin, 93059 Regensburg (DE)
(74) Vertreter: Epping - Hermann - Fischer
(86) Internationale Anmeldenummer: PCT/DE2008/000507
(87) Internationale Veröffentlichungsnummer: WO 2008/119327

(56) Entgegenhaltungen:
- EP-A- 1 174 931
- WO-A-2005/008789
- DE-A1-102006 004 397

## Beschreibung

Die vorliegende Anmeldung nimmt die Priorität der deutschen Patentanmeldung Nr. 102007015474.9 in Anspruch, deren Offenbarungsgehalt hiermit durch Rückbezug aufgenommen wird.

Gegenstand der vorliegenden Erfindung ist ein optoelektronisches Bauelement gemäß dem Oberbegriff von Anspruch 1 sowie ein Verfahren zum Herstellen eines derartigen optoelektronischen Bauelements.

In der US 5,040,868 ist ein Licht emittierendes optoelektronisches Bauelement offenbart. Es weist einen Gehäusegrundkörper mit einer Umhüllung auf, die zwei elektrische Leiterbahnen eines Leiterrahmens umformt sowie eine Ausnehmung aufweist, in der ein elektromagnetische Strahlung emittierender Lumineszenzdiodenchip elektrisch leitend und mechanisch montiert ist. Die Ausnehmung ist mit einer strahlungsdurchlässigen Gussmasse vergossen, durch die eine Auskopplung elektromagnetischer Strahlung aus dem Lumineszenzdiodenchip verbessert wird und der Lumineszenzdiodenchip vor äußeren Einflüssen geschützt ist. Gemäß einer offenbarten Ausführungsform ist die Umhüllung des Gehäusegrundkörpers aus hochreflektivem Kunststoff gebildet.

In der EP-A-1174931 ist ein optoelektronisches Bauelement offenbart.

Es ist eine Aufgabe der vorliegenden Erfindung, ein alternativ ausgebildetes optoelektronisches Bauelement der eingangs genannten Art bereitzustellen, das für spezielle Anwendungen Vorteile gegenüber herkömmlichen Bauelementen aufweist. Zudem soll ein Verfahren zum Herstellen eines derartigen optoelektronischen Bauelements angegeben werden.

Diese Aufgabe wird durch ein optoelektronisches Bauelement oder ein Verfahren gemäß den unabhängigen Patentansprüchen gelöst. Vorteilhafte Ausführungsformen und bevorzugte Weiterbildungen des Bauelementes und des Verfahrens sind Gegenstand der abhängigen Patentansprüche.

Es wird ein optoelektronisches Bauelement angegeben, das eine Nutzstrahlung emittiert. Es umfasst ein Gehäuse, das einen Gehäusegrundkörper mit einer Gehäusekavität aufweist, und einen in der Gehäusekavität angeordneten Lumineszenzdiodenchip. Zumindest ein Grundkörpermaterial des Gehäusegrundkörpers ist zum Verringern seiner Reflektivität gezielt mit strahlungsabsorbierenden Partikeln versetzt.

Bei einigen Anwendungen können Reflexionen von Fremdlicht an einem Gehäuse eines optoelektronischen Bauelements störend sein. Die Intensität derartiger Reflexionen kann durch Beimengung der strahlungsabsorbierenden Partikel in das Grundkörpermaterial signifikant verringert werden. Dadurch, dass die strahlungsabsorbierenden Partikel in dem Grundkörpermaterial eingebracht sind, kann eine besonders gute absorbierende Wirkung realisiert werden.

Es kann beispielsweise grundsätzlich eine bessere Wirkung erzielt werden als bei einem strahlungsdurchlässigen und/oder stark reflektierenden Gehäusegrundkörper, der lediglich auf einer Außenfläche mit einer strahlungsabsorbierenden Schicht wie z.B. einer schwarzen Farbschicht versehen ist. Es kann insbesondere auf eine derartige auf dem Grundkörper aufgebrachte strahlungsabsorbierende Schicht verzichtet werden. Alternativ ist es jedoch auch möglich, den Grundkörper zusätzlich zumindest an Teilen der Außenfläche des Bauelements mit einer strahlungsabsorbierenden Schicht zu versehen.

Gemäß einer weiteren Ausführungsform des Bauelements weist das Gehäuse zusätzlich oder alternativ ein für die Nutzstrahlung durchlässiges Gehäusematerial auf, das zum Verringern seiner Reflektivität gezielt mit strahlungsabsorbierenden Partikeln versetzt ist. In dem Fall, dass sowohl das Gehäusematerial als auch das Grundkörpermaterial mit strahlungsabsorbierenden Partikeln versetzt ist, können für diese Materialien sowohl die gleichen als auch voneinander unterschiedliche strahlungsabsorbierende Partikel verwendet werden.

Unter dem Begriff "strahlungsabsorbierende Partikel" sind im Zusammenhang mit der vorliegenden Anmeldung keine Leuchtstoffe zu verstehen, die für eine von dem Lumineszenzdiodenchip emittierte Strahlung eines ersten Wellenlängenbereiches absorbierend sind und durch diese Strahlung angeregt werden, um eine elektromagnetische Strahlung eines zweiten Wellenlängenbereiches zu emittieren, der sich vom ersten Wellenlängenbereich unterscheidet. Mit anderen Worten remittieren die strahlungsabsorbierenden Partikel keine optische Strahlung, wenn sie eine elektromagnetische Nutzstrahlung des Bauelements absorbiert haben. Es ist dagegen möglich, dass die strahlungsabsorbierenden Partikel die Nutzstrahlung nicht nur absorbieren, sondern zum Teil auch streuen.

Für den Fall, dass sowohl in dem Gehäusematerial als auch in dem Grundkörpermaterial strahlungsabsorbierende Partikel enthalten sind, ist gemäß einer Ausführungsform die Konzentration der strahlungsabsorbierenden Partikel in dem Grundkörpermaterial größer als in dem strahlungsdurchlässigen Gehäusematerial. In einer Ausgestaltung ist die Konzentration mindestens zweimal so groß, gemäß einer weiteren Ausgestaltung ist die Konzentration in dem Grundkörpermaterial mindestens fünfmal so groß wie in dem Gehäusematerial.

Gemäß einer weiteren Ausführungsform ist mindestens ein weiterer Lumineszenzdiodenchip oder sind mindestens zwei weitere Lumineszenzdiodenchips in der Gehäusekavität angeordnet. Bei den in der Gehäusekavität angeordneten Lumineszenzdiodenchips kann es sich um gleichartige Chips handeln, die alle im Wesentlichen elektromagnetische Strahlung desselben Wellenlängenspektrums emittieren. Alternativ ist mindestens einer der Lumineszenzdiodenchips von einer unterschiedlichen Art und emittiert bei seinem Betrieb elektromagnetische Strahlung eines Wellenlängenspektrums, das zu dem Emissionsspektrum der übrigen Lumineszenzdiodenchips unterschiedlich ist. Es können auch alle Lumineszenzdiodenchips voneinander unterschiedliche Emissionsspektren aufweisen. In einer Ausgestaltung des Bauelements emittieren alle Lumineszenzdiodenchips bei ihrem Betrieb elektromagnetische Strahlung, die zumindest zu einem Teil für das menschliche Auge sichtbar ist.

Bei einem Bauelement gemäß einer weiteren Ausführungsform sind in der Gehäusekavität Streupartikel zum Streuen der Nutzstrahlung angeordnet. Zusätzlich oder alternativ sind Streupartikel zum Streuen der Nutzstrahlung in dem für die Nutzstrahlung durchlässigen Gehäusematerial enthalten. Streupartikel werden in der Fachwelt auch Diffusorpartikel genannt. Durch derartige Streupartikel lässt sich eine homogenere Abstrahlcharakteristik des optoelektronischen Bauelements realisieren. Es ist insbesondere möglich, mittels der Streupartikel die Wirkung zu erzielen, dass das optoelektronische Bauelement eine größere effektive Emissionsfläche aufweist, verglichen mit einem Bauelement ohne Streupartikel.

Durch eine Kombination von Streupartikeln und strahlungsabsorbierenden Partikeln kann einerseits eine Reflektivität hinsichtlich äußerer Fremdstrahlung verringert werden und andererseits eine für einige Anwendungen vorteilhafte Abstrahlcharakteristik von Nutzstrahlung realisiert werden. Bei einer derartigen Kombination wirken die Streupartikel und die strahlungsabsorbierenden Partikel zusammen.

Die strahlungsabsorbierenden Partikel des Grundkörpermaterials sind gemäß einer weiteren Ausgestaltung des Bauelements für einen Teil oder für die Gesamtheit des Wellenlängenspektrums der Nutzstrahlung absorbierend. Das Wellenlängenspektrum der Nutzstrahlung umfasst in einer Ausführungsform einen für das menschliche Auge sichtbaren Bereich. Zusätzlich oder alternativ sind die strahlungsabsorbierenden Partikel des Grundkörpermaterials für einen Teil oder für die Gesamtheit des Wellenlängenspektrums der von dem Lumineszenzdiodenchip oder den Lumineszenzdiodenchips bei Betrieb emittierten Strahlung absorbierend.

Gemäß einer weiteren Ausführungsform weisen auch die strahlungsabsorbierenden Partikel des Gehäusematerials eine Absorption für einen Teil oder den gesamten Bereich des Wellenlängenspektrums der Nutzstrahlung und/oder des Lumineszenzdiodenchips auf.

In einer Ausgestaltung des Bauelements variiert der Absorptionskoeffizient der strahlungsabsorbierenden Partikel des Grundkörpermaterials und/oder des Gehäusematerials im gesamten Spektrum der Nutzstrahlung um weniger als 10 %. Insbesondere weisen die Partikel im relevanten Wellenlängenbereich eine vernachlässigbar große Wellenlängenabhängigkeit in der Absorption auf.

Die strahlungsabsorbierenden Partikel des Gehäusematerials und/oder des Grundkörpermaterials weisen in einer weiteren Ausführungsform des Bauelements Ruß auf. Ruß ist allgemein als Nebenprodukt bei Verbrennungsprozessen bekannt. Zudem wird er industriell produziert und als Farbstoff, insbesondere als verstärkender Füllstoff in Autoreifen verwendet. Ruß weist in der Regel eine relativ starke Wellenlängenabhängigkeit in seinem Absorptionsverhalten auf, was insbesondere auch für sichtbares Licht gilt. Es wurde jedoch festgestellt, dass bestimmte Formen von Ruß im sichtbaren Wellenlängenbereich eine sehr geringe Wellenlängenabhängigkeit im Absorptionsverhalten aufweisen.

Industrieruß wird mit verschiedenen definierten technischen Eigenschaften produziert. Ruß liegt in Form von Aggregaten vor, die sich aus einer Mehrzahl von Primärpartikeln zusammensetzen. Für eine Verwendung als strahlungsabsorbierende Partikel eignet sich insbesondere Ruß mit besonders kleinen Primärpartikelgrößen. Zudem kann es vorteilhaft sein, Industrieruß mit kompakter Aggregatstruktur zu verwenden. Für derartige Rußarten wird in Fachkreisen der englische Ausdruck "low structure carbon black" (LSCB) verwendet. Die Aggregate weisen in einer Ausgestaltung des Bauelements eine durchschnittliche Ausdehnung von kleiner als oder gleich 1 µm auf.

Die strahlungsabsorbierenden Partikel des Gehäusematerials und/oder des Grundkörpermaterials sind gemäß einer weiteren Ausführungsform des Bauelements elektrisch isolierend. Damit ist es möglich, dass das für die Nutzstrahlung durchlässige Gehäusematerial unmittelbar an den Lumineszenzdiodenchip angrenzt, ohne dass die Gefahr einer Kurzschlussbildung auf Grund elektrisch leitender Partikel besteht. Es können alternativ auch elektrisch leitende Partikel verwendet werden. Wenn die Konzentration von diesen im Gehäusematerial ausreichend gering ist, kann das Risiko einer Kurzschlussbildung ebenfalls zumindest weitgehend vermieden werden. Die maximale Konzentration hängt dabei von der Aggregatgröße ab. Mit LSCB, das eine, verglichen mit gewöhnlichen Rußpartikeln, geringe Aggregatgröße aufweist, kann eine höhere Konzentration bei gleichem Risiko für eine Kurzschlussbildung verwendet werden.

Allgemein weisen die strahlungsabsorbierenden Partikel des Gehäusematerials und/oder des Grundkörpermaterials mit Vorteil einen mittleren Partikeldurchmesser von kleiner als oder gleich 100 nm auf (Teilchenmittel). Derart kleine Partikel lassen sich besonders gut in einem Gehäusematerial dispergieren. Im Fall von Ruß weisen die Primärpartikel der Agglomerate in einer Ausgestaltung des Bauelements einen derart geringen mittleren Partikeldurchmesser auf.

Das für die Nutzstrahlung durchlässige Gehäusematerial und/oder das Grundkörpermaterial weist gemäß einer weiteren Ausführungsform eine Gussmasse oder eine Pressmasse auf. Mit derartigen Materialien lassen sich Gehäuseteile von wohldefinierten Formen und Ausmessungen herstellen. Gussmassen lassen sich vergießen oder beispielsweise in einem Spritzgussverfahren formen. Pressmassen können in einem Spritzpressverfahren verarbeitet werden.

In einer zweckmäßigen Ausführungsform weist das für die Nutzstrahlung durchlässige Gehäusematerial mindestens eines der Materialien aus der Gruppe bestehend aus Epoxydharz, Acrylat, Silikon, Thermoplast und Hybridmaterial mit mindestens einem dieser Materialien auf. Es kann grundsätzlich auch ein andersartiges Hybridmaterial verwendet werden, d.h. ein Hybridmaterial, dass keines der Materialien Epoxydharz, Acrylat, Silikon und Thermoplast enthält.

In einer weiteren Ausführungsform ist der Lumineszenzdiodenchip mittels des für die Nutzstrahlung durchlässigen Gehäusematerials umkapselt oder umformt. Insbesondere ist es möglich, dass das Gehäusematerial unmittelbar an den Lumineszenzdiodenchip angrenzt.

In einer Ausgestaltung des Bauelements ist die Gehäusekavität zumindest teilweise mit dem für die Nutzstrahlung durchlässigen Gehäusematerial gefüllt. Das Füllen der Gehäusekavität erfolgt bevorzugt durch Vergießen mit der für die Nutzstrahlung durchlässigen Masse.

Eine weitere Ausführungsform des Bauelements sieht vor, dass das Bauelement einen Gehäusekörper mit einer Außenfläche aufweist. Das für die Nutzstrahlung durchlässige Gehäusematerial ist zumindest auf die Außenfläche des Gehäusekörpers aufgebracht.

Zweckmäßigerweise kann das auf der Außenfläche des Gehäusekörpers aufgebrachte Gehäusematerial in Form einer Folie vorliegen. Diese ist beispielsweise durch Auflaminieren oder mittels eines Klebstoffes auf der Außenfläche des Gehäusekörpers befestigt. Die Folie weist mit Vorteil eine konstante Dicke auf. Sie ist zweckmäßigerweise flexibel ausgeführt. Alternativ ist es auch möglich, dass die Dicke der Folie variiert. Dies lässt sich beispielsweise bewerkstelligen, in dem eine Folie mit konstanter Dicke gezielt strukturiert wird.

Zusätzlich oder alternativ ist es auch möglich, eine Folie als Gehäusematerial zu verwenden, die mit strahlungsabsorbierenden Partikeln versetzt ist.

Es wird ein Verfahren zum Herstellen eines eine Nutzstrahlung emittierenden optoelektronischen Bauelements angegeben. Bei diesem wird ein Gehäusegrundkörper mit einer Gehäusekavität und mit einem Grundkörpermaterial bereitgestellt oder gefertigt, wobei das Grundkörpermaterial gezielt mit strahlungsabsorbierenden Partikeln versetzt ist. Weiterhin wird ein Lumineszenzdiodenchip bereitgestellt. Der Lumineszenzdiodenchip wird in der Gehäusekavität montiert.

In einer Ausführungsform des Verfahrens wird zusätzlich ein für die Nutzstrahlung durchlässiges Material bereitgestellt, wobei das Material gezielt mit strahlungsabsorbierenden Partikeln versetzt ist. Nachfolgend erfolgt ein Anordnen des für die Nutzstrahlung durchlässigen Materials in einem Strahlengang der elektromagnetischen Strahlung, die von dem Lumineszenzdiodenchip bei dessen Betrieb zu emittieren ist. Gemäß einer weiteren Ausführungsform wird zumindest ein Teil des für die Nutzstrahlung durchlässigen Materials in der Gehäusekavität angeordnet. Gemäß einer Ausgestaltung wird der Lumineszenzdiodenchip mit dem für die Nutzstrahlung durchlässigen Material umkapselt oder umformt.

Eine weitere Ausführungsform des Verfahrens sieht das Bereitstellen eines Bauelements vor, wobei das Bauelement den Lumineszenzdiodenchip und den Gehäusegrundkörper enthält. Es wird zumindest ein Teil der für die Nutzstrahlung durchlässigen Masse auf eine Außenfläche des Gehäusekörpers aufgebracht.

Gemäß einer weiteren Ausführungsform wird zumindest ein Teil des für die Nutzstrahlung durchlässigen Materials vor dem Aufbringen auf der Außenfläche des Gehäusekörpers in Form einer vorgefertigten Materialschicht bereitgestellt. Zusätzlich oder alternativ ist vorgesehen, dass zumindest ein Teil des für die Nutzstrahlung durchlässigen Materials vor dem Aufbringen auf der Außenfläche des Gehäuses in Form einer Folie bereitgestellt wird.

Weitere Vorteile, bevorzugte Ausführungsformen und Weiterbildungen des Bauelements und des Verfahrens ergeben sich aus den im Folgenden in Verbindung mit den Figuren erläuterten Ausführungsbeispielen. Es zeigen:
- Figur 1: eine schematische Schnittansicht eines ersten Ausführungsbeispiels des optoelektronischen Bauelements,
- Figur 2: eine schematische Schnittansicht eines zweiten Ausführungsbeispiels des optoelektronischen Bauelements,
- Figur 3: eine schematische Schnittansicht eines dritten Ausführungsbeispiels des optoelektronischen Bauelements,
- Figur 4: ein Diagramm, bei dem eine relative Strahlungsintensität verschiedener optoelektronischer Bauelemente in Abhängigkeit der Konzentration strahlungsabsorbierender Partikel im strahlungsdurchlässigen Gehäusematerial aufgetragen ist, und
- Figur 5: eine schematische Draufsicht eines vierten Ausführungsbeispiels des optoelektronischen Bauelements.

In den Ausführungsbeispielen und Figuren sind gleiche oder gleich wirkende Bestandteile jeweils mit den gleichen Bezugszeichen versehen. Die dargestellten Bestandteile sowie die Größenverhältnisse der Bestandteile untereinander sind nicht notwendigerweise als maßstabsgerecht anzusehen. Vielmehr sind einige Details der Figuren zum besseren Verständnis übertrieben groß dargestellt.

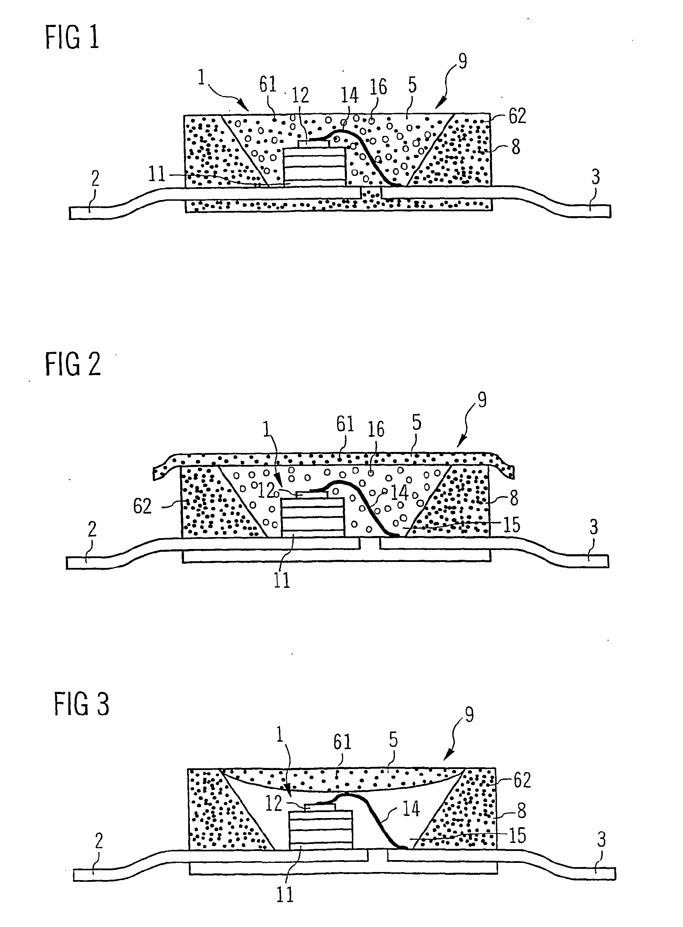

Bei dem in Figur 1 dargestellten optoelektronischen Bauelement ist ein Lumineszenzdiodenchip 1 mittels eines elektrisch leitenden Verbindungsmittels, zum Beispiel ein metallisches Lot oder ein Klebstoff, mit einem Rückseitenkontakt 11 auf einem ersten elektrischen Anschluss 2 eines Leiterrahmens befestigt. Auf einer dem Rückseitenkontakt 11 abgewandten Seite weist der Lumineszenzdiodenchip 1 einen Vorderseitenkontakt 12 auf, der mittels eines Bonddrahtes 14 mit einem zweiten elektrischen Anschluss 3 des Leiterrahmens elektrisch leitend verbunden ist.

Freie Oberflächen des Lumineszenzdiodenchip 1 und der Bonddraht 14 sind unmittelbar von einem Gehäusematerial 5 umschlossen, das für eine von dem Lumineszenzdiodenchip 1 bei dessen Betrieb emittierte elektromagnetische Strahlung durchlässig ist. Dieses Gehäusematerial 5 ist beispielsweise eine Vergussmasse, die mehr als 70 Gew-% Epoxidgießharz aufweist. Darüber hinaus kann die Vergussmasse noch Zusatzstoffe wie zum Beispiel Diethylenglykolmonomethylether, Tegopren 6875-45 und Aerosil 200 aufweisen.

Alternativ oder zusätzlich weist das Gehäusematerial 5 z.B. mindestens ein Hybridmaterial auf. Mit Hybridmaterialien ist es möglich, die positiven Eigenschaften verschiedener Materialien miteinander zu kombinieren. Dadurch können beispielsweise nachteilige Eigenschaften eines Materials abgeschwächt oder eliminert werden. Es wird z.B. ein Polymer-Hybridmaterial verwendet. Als Hybridmaterialien kommen z.B. Silikon-modifizierte Epoxidharze in Frage, die bei Einwirkung von ultraviolettem Licht weniger stark altern als herkömmliche Epoxidharze, im Übrigen jedoch im Wesentlichen die positiven physikalischen Eigenschaften herkömmlicher Epoxidharze aufweisen. Es ist auch möglich, mindestens ein Epoxidharz und mindestens ein Silikon miteinander zu mischen. Beispiele für derartige geeignete Hybridmaterialien sind beispielsweise in der US 2002/0192477 A1 oder in der US 2005/0129957 A1 angegeben, deren Offenbarungsgehalt insofern hiermit durch Rückbezug aufgenommen wird.

Es ist weiterhin möglich, Silikon mit Acrylat oder Silikon mit Acrylat und Epoxidharz zu kombinieren. Selbstverständlich ist es auch möglich, kein Hybridmaterial zu verwenden und beispielsweise ein Acrylat, ein Silikon oder ein Thermoplast als Bestandteil des Gehäusematerials 5 zu verwenden.

In die Vergussmasse 5 sind zum Beispiel strahlungsabsorbierende Partikel 61 gemischt.

Das in Figur 1 dargestellte Ausführungsbeispiel des optoelektronischen Bauelements weist einen Gehäusegrundkörper 8 mit einer Ausnehmung 9 auf. Der Lumineszenzdiodenchip 1 ist in dieser Ausnehmung auf dem ersten elektrischen Anschluss 2 eines Leiterrahmens aufgebracht. Die Ausnehmung 9 ist mit dem Gehäusematerial 5 gefüllt, das für eine von dem Bauelement emittierte Nutzstrahlung durchlässig ist.

Der Gehäusegrundkörper 8 ist beispielsweise mittels Spritzguss ausgebildet, was vor der Montage des Lumineszenzdiodenchips 1 erfolgen kann. Das Grundkörpermaterial weist zum Beispiel Polyphtalamid (PPA) auf, das in einer Ausgestaltung mit Glasfasern und/oder Mineralstoffen gefüllt sein kann. Es ist mit strahlungsabsorbierenden Partikeln 62 versetzt.

Bei den strahlungsabsorbierenden Partikeln 61, 62 des strahlungsdurchlässigen Gehäusematerials 5 und/oder des Grundkörpermaterials des Grundkörpers 8 handelt es sich zum Beispiel um einen industriell hergestellten Ruß mit definierten technischen Eigenschaften. Die Rußpartikel setzen sich aus einer Mehrzahl von Primärpartikeln zusammen, die gemeinsam eine Aggregatstruktur bilden. Diese Aggregatstruktur ist bevorzugt möglichst kompakt.

Die Primärpartikel der Rußpartikel weisen einen mittleren Durchmesser von kleiner als oder gleich 100 nm auf. Beispielsweise beträgt der mittlere Durchmesser 50 bis 60 nm. Unter dem mittleren Durchmesser ist das Teilchenmittel der gemessenen Durchmesser zu verstehen. Die Aggregate weisen einen mittleren Durchmesser von kleiner als oder gleich 1 µm auf. Ein geeigneter Industrieruß ist beispielsweise das kommerziell erhältliche "Printex 25", das von dem Unternehmen Degussa hergestellt wird. Es handelt sich dabei um ein so genanntes "Low structure carbon black" (LSCB) mit kompakter Aggregatstruktur.

Die Partikelgröße der Primärpartikel und der Aggregate kann mit unterschiedlichen Methoden bestimmt werden. Beide Größen können beispielsweise mittels eines Transmissionselektronenmikroskops (TEM) bestimmt werden. Die Aggregatgröße kann beispielsweise auch mittels Streulicht-Intensitätsmessungen ermittelt werden. Für die Bestimmung der Primärteilchengröße eignen sich zum Beispiel auch differentielle Mobilitäts-Analysatoren (DMA), die üblicherweise benutzt werden, um den elektrischen Mobilitätsdurchmesser von nanoskaligen Aerosolen zu bestimmen. Derartige sowie weitere mögliche Meßmethoden zum Ermitteln der relevanten Partikeldurchmesser sind dem Fachmann bekannt.

Im Unterschied zu beispielsweise lang gestreckten Aggregatstrukturen haben kompakte Aggregatstrukturen den Vorteil, dass sie eine elektrische Leitfähigkeit des Materials, in das sie eingemischt sind, in geringerem Maße beeinflussen. Es gibt Untersuchungen, die zeigen, dass LSCB-Partikel erst bei einer viermal so hohen Volumenkonzentration als so genannte "High structure carbon black" (HSCB) einen Übergang von einem nicht leitenden zu einem leitenden Zustand des Matrixmaterials verursachen. Bei LSCB-Partikeln beginnt dieser Übergang beispielsweise ab einer Volumenkonzentration von zirka 40 Volumen-%, während dies bei HSCB-Partikeln bereits bei einer Konzentration von 10 Volumen-% der Fall sein kann. Das Vorhandensein von Salzen kann diesen Übergang zu niedrigeren Konzentrationen verschieben.

Oftmals bilden sich aus Rußaggregaten Agglomerate, die eine Größe in der Größenordnung von mehreren Mikrometern oder von mehreren 10 µm aufweisen können. Derartige Agglomerate sollten möglichst vermieden werden. Beim Einmischen der Rußpartikel in die ungehärtete Vergussmasse werden diese mit Hilfe von Rotationsmixern, die bei sehr hohen Geschwindigkeiten betrieben werden, homogen eingearbeitet. Bei diesem Einarbeitungsprozess treten hohe Scherkräfte auf, die bewirken, dass etwaige Agglomerate zumindest zu einem Großteil aufgebrochen werden.

Die strahlungsabsorbierenden Partikel 61 werden zum Beispiel mit einer Konzentration von größer als 0,01 Gew.-% und einschließlich 0,06 Gew.-% in das Gehäusematerial 5 gemischt. Insbesondere kann diese Konzentration kleiner als oder gleich 0,04 Gew.-% sein.

In dem Grundkörpermaterial des Grundkörpers 8 beträgt die Konzentration der strahlungsabsorbierenden Partikel 62 zum Beispiel mehr als die Konzentration der strahlungsabsorbierenden Partikel 61 im Gehäusematerial 5. Die Konzentration liegt im Grundkörpermaterial z.B. zwischen einschließlich 0,1 Gew.-% und einschließlich 20 Gew.-%, bevorzugt zwischen 0,2 Gew.-% und 10 Gew.-%.

Zusätzlich oder alternativ zu Rußpartikeln können die strahlungsabsorbierenden Partikel des Gehäusematerials 5 und/oder des Grundkörpers zum Beispiel auch Graphitpartikel aufweisen.

In dem Gehäusematerial 5 sind zusätzlich Streupartikel 16 eingemischt. Die Konzentration der Streupartikel 16 liegt zum Beispiel bei maximal 10 Gew.-%. Mit Vorteil liegt diese Konzentration bei einem Wert zwischen einschließlich 0,1 Gew.-% und 5 Gew.-%, insbesondere zwischen 0,75 Gew.-% und 4 Gew.-%. Zum Beispiel liegt die Konzentration der Streupartikel bei etwa 1,25 Gew.-% oder bei 3 Gew.-%.

Die Streupartikel weisen zum Beispiel CaF-Partikel und/oder TiO₂-Partikel auf oder bestehen aus derartigen Partikeln. Dies sind selbstverständlich nicht die einzigen möglichen Partikel für Streupartikel. Der Fachmann auf dem Gebiet der Optoelektronik bzw. der Optik wird problemlos die für seine Zwecke geeigneten Streupartikel herausfinden, deren Größe und Materialzusammensetzung unter anderem von der Wellenlänge der zu streuenden Strahlung abhängen kann. Die Wahl der geeigneten Diffusorpartikel wird insbesondere von der Wellenlänge der von den Lumineszenzdiodenchips 1 emittierten oder zu empfangenden elektromagnetischen Strahlung abhängen.

Ein Vorteil einer derartigen Verwendung von Streupartikeln 16 liegt darin, dass diese nicht nur auf die von den Lumineszenzdiodenchips emittierte Strahlung wirken können, sondern auch auf die von außen einfallende Fremdstrahlung. Im Gegensatz zu einer klaren Vergussmasse ohne Streupartikel 16 wird die Fremdstrahlung deshalb nicht zurückgespiegelt, sondern diffus reflektiert. Somit kann nicht nur durch die strahlungsabsorbierenden Partikel, sondern zusätzlich oder alternativ auch mittels der Streupartikel 16 ein verbesserter Kontrast des Bauelements realisiert werden.

Durch eine verminderte Reflektivität des Gehäuses können zum Beispiel störende Reflexionen von Sonnenlicht am Bauelement verringert werden.

Der Lumineszenzdiodenchip weist z.B. eine Halbleiterschichtenfolge 7 auf, die auf Nitrid-Verbindungshalbleitermaterialien basiert. Nitrid-Verbindungshalbleitermaterialien sind Verbindungshalbleitermaterialien, die Stickstoff enthalten, wie die Materialien aus dem System InₓAlyGB_{l-x-y}N mit 0 ≤ x ≤ 1, 0 ≤ y ≤ 1 und x+y ≤ 1. Unter die Gruppe von strahlungsemittierenden Lumineszenzdiodenchips auf Basis von Nitrid-Verbindungshalbleitermaterial fallen vorliegend insbesondere solche Lumineszenzdiodenchips, bei denen die Halbleiterschichtenfolge 7 mindestens eine Einzelschicht enthält, die ein Material aus dem Nitridverbindungshalbleiter-material-System aufweist.

Alternativ basiert die Halbleiterschichtenfolge 7 z.B. auf Phosphid-Verbindungshalbleitermaterialien oder auf Arsenid-Verbindungshalbleitermaterialien. Darunter fallen Materialien aus dem System InₓAlyGa_{l-x-y}P mit 0 ≤ x ≤ 1, 0 ≤ y ≤ 1 und x+y ≤ 1 oder aus dem System InₓAlyGa_{l-x-y}As mit 0 ≤ x ≤ 1, 0 ≤ y ≤ 1 und x+y ≤ 1.

Die Halbleiterschichtenfolge 7 kann beispielsweise einen herkömmlichen pn-Übergang, eine Doppelheterostruktur, eine Einfach-Quantentopfstruktur (SQW-Struktur) oder eine Mehrfach-Quantentopfstruktur (MQW-Strukur) aufweisen. Solche Strukturen sind dem Fachmann bekannt und werden von daher an dieser Stelle nicht näher erläutert.

Die in Figur 2 und 3 veranschaulichten Ausführungsbeispiele des Bauelements unterscheiden sich von dem vorhergehend anhand Figur 1 erläuterten Ausführungsbeispiel dadurch, dass die Ausnehmung 9 des Gehäusegrundkörpers 8 jeweils mit einem Füllmaterial 15 gefüllt ist, welches frei von strahlungsabsorbierenden Partikeln ist. Die Ausnehmung 9 ist beispielsweise derart mit dem Füllmaterial 15 gefüllt, dass der in der Ausnehmung 9 montierte Lumineszenzdiodenchip 1 von dem Gehäusematerial 15 eingekapselt ist.

Das innere Füllmaterial 15 besteht beispielsweise aus einem in der Leuchtdiodentechnik herkömmlich verwendeten Epoxid-, Silikon- oder Acrylatharz oder aus einem anderen geeigneten strahlungsdurchlässigen Material wie zum Beispiel anorganisches Glas. Das Füllmaterial 15 enthält z.B. Streupartikel 16, siehe Figur 2.

Auf dieses Füllmaterial 15 ist ein Gehäusematerial 5 aufgebracht, das mit strahlungsabsorbierenden Partikeln 61 versetzt ist. Das Gehäusematerial 5 und die strahlungsabsorbierenden Partikel können wie vorhergehend im Zusammenhang mit dem in Figur 1 dargestellten Ausführungsbeispiel erläutert beschaffen sein. Das gleiche gilt für den Gehäusegrundkörper 8 und die darin enthaltenen strahlungsabsorbierenden Partikel 62. Der Gehäusegrundkörper 8 kann zum Beispiel auch auf einer dem Lumineszenzdiodenchip 1 abgewandten Seite der elektrischen Anschlüsse frei von strahlungsabsorbierenden Partikeln 61 sein, siehe Figur 2 oder Figur 3.

Alternativ zu den in Figur 2 oder 3 dargestellten Ausführungsbeispielen kann auch ein den Lumineszenzdiodechip 1 unmittelbar umkapselnder Teil des Gehäuses mit strahlungsabsorbierenden Partikeln 61 versetzt sein, auf dem wiederum ein transparentes Füllmaterial aufgebracht sein kann, das frei von strahlungsabsorbierenden Partikeln ist.

Bei den in den Figuren 2 und 3 dargestellten Bauelementen bilden der Gehäusegrundkörper 8 und das Füllmaterial 15 einen Gehäusekörper. Auf eine Außenfläche dieses Gehäusekörpers ist das weitere Gehäusematerial 5 aufgebracht.

Bei dem in Figur 2 dargestellten Bauelement ist das die strahlungsabsorbierenden Partikel 61 enthaltende Gehäusematerial 5 schichtförmig auf der Außenfläche des Gehäusekörpers 8, 15 aufgebracht. Bei der Herstellung des Bauelements kann das Gehäusematerial 5 in Form einer vorgefertigten Schicht mit beispielsweise konstanter Dicke bereitgestellt werden, bevor es auf die Außenfläche des Gehäusekörpers 8, 15 aufgebracht wird. Das Aufbringen erfolgt zum Beispiel mittels Kleben oder Auflaminieren. Es ist insbesondere möglich, das schichtförmige Gehäusematerial 5 als eine Folie bereitzustellen, die flexibel ist und die sich somit auch auf unebene Außenflächen des Gehäusekörpers aufbringen lässt. Nach dem Aufbringen kann die Folie beispielsweise gehärtet werden und ihre Flexibilität verlieren.

Ein Gehäusekörper 8, 15 mit einer unebenen Außenfläche ist beispielsweise in Figur 3 dargestellt. Auf diese lässt sich beispielsweise ein als Folie bereitgestelltes Gehäusematerial 5 mit strahlungsabsorbierenden Partikeln 61 aufbringen. Diese Möglichkeit ist jedoch nicht in Figur 3 dargestellt. Bei dem dargestellten Ausführungsbeispiel ist die Ausnehmung 9 nur teilweise mit dem Gehäusematerial 15 gefüllt. Die Außenfläche dieses Gehäusematerials 15 weist eine konkave Krümmung auf und bildet somit eine wannenartige oder beckenartige Vertiefung. In diese Vertiefung ist ein Gehäusematerial 5 eingefüllt, das strahlungsabsorbierende Partikel 61 aufweist. Das Auffüllen der Vertiefung erfolgt beispielsweise durch Bereitstellen des Gehäusematerials 5 in Form einer ungehärteten Masse, Vergießen der durch die Außenfläche des Füllmaterials 15 gebildeten Vertiefung mit dieser Masse sowie durch nachfolgendes Aushärten des Gehäusematerials 5.

Bei dem in Figur 3 dargestellten Bauelement weist das Gehäusematerial 5 eine schichtartige Form auf, die jedoch keine konstante Dicke aufweist. Im Bereich der optischen Achse des Bauelements weist das Gehäusematerial 5 beispielsweise eine größte Dicke auf, die mit größer werdendem Abstand zur optischen Achse des Bauelements zunehmend kleiner wird. Durch derartige Gehäusematerialschichten 5 mit variierender Dicke lässt sich nicht nur eine vom Bauelement emittierte Lichtintensität oder Strahlungsintensität, sondern auch eine Abstrahlcharakteristik des Bauelements gezielt einstellen. Die Variation der Dicke des Gehäusematerials 5 kann selbstverständlich grundsätzlich beliebig sein und ist auf das im Einzelfall vorliegende Bauelement und die zu erzielende Abstrahlcharakteristik abgestimmt.

Es ist alternativ zu dem in Figur 3 dargestellten Beispiel auch möglich, dass die Gehäusematerialschicht 5 in Außenbereichen eine größere Dicke aufweist als in der Mitte. Bei allen Ausführungsbeispielen ist es z.B. zusätzlich oder alternativ zu der Verwendung eines mit strahlungsabsorbierenden Partikeln 61 versetzten Gehäusematerials auch möglich, dass der Lumineszenzdiodenchip mit einer Folie versehen ist, die mit strahlungsabsorbierenden Partikeln versetzt ist. Die Folie weist beispielsweise ein Silikon oder ein Hybridmaterial mit einem Epoxidharz auf. Die strahlungsabsorbierenden Partikel können wie vorhergehend bereits beschrieben beschaffen sein.

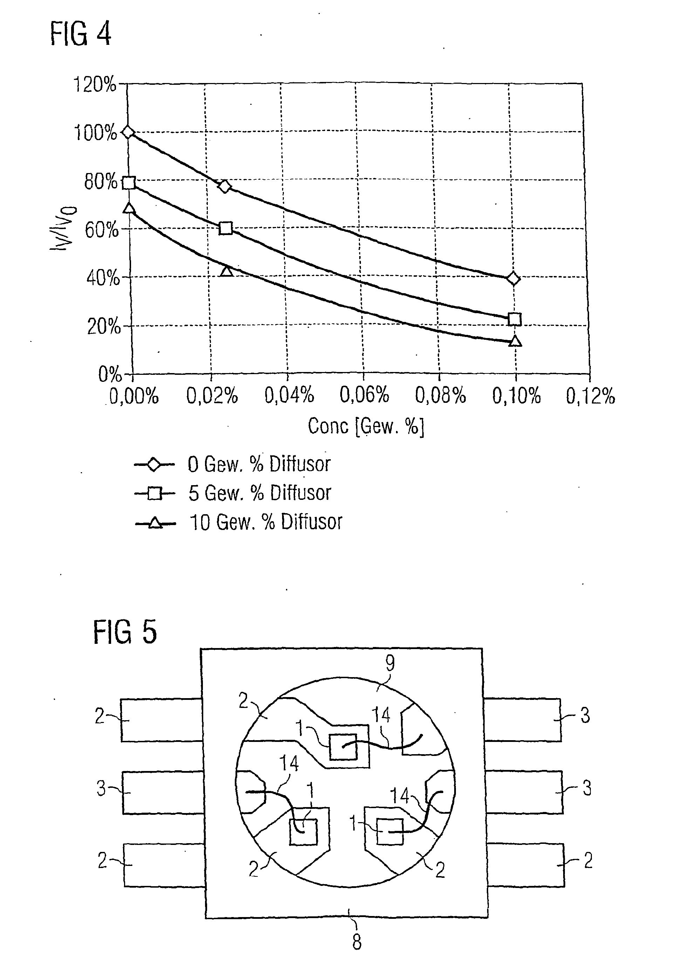

Die in Figur 4 dargestellten Messergebnisse wurden mit optoelektronischen Bauelementen erhalten, die in der Art wie vorhergehend anhand Figur 1 beschrieben ausgeführt sind. Es wurde die relative Strahlungsintensität (relative Helligkeit) Iv/Ivo für verschiedene Bauelemente gemessen. Die Messergebnisse sind in Figur 4 in Abhängigkeit der Konzentration conc der strahlungsabsorbierenden Partikel im Gehäusematerial 5 aufgetragen, wobei die Konzentration in Gew.-% angegeben ist.

Es wurden drei verschiedene Messreihen durchgeführt, bei denen jeweils eine im Wesentlichen konstante Konzentration von Streupartikeln 16 im Gehäusematerial 5 enthalten ist. In einer ersten Messreihe sind keine Streupartikel in dem Gehäusematerial 5 enthalten. In einer zweiten Messreihe sind etwa 5 Gew.-% Streupartikel in dem Gehäusematerial 5 enthalten und in einer dritten Messreihe sind etwa 10 Gew.-% Streupartikel in dem Gehäusematerial 5 enthalten.

Es lässt sich erkennen, dass die Strahlungsintensität mit zunehmendem Anteil an Streupartikeln und für einen gleichen Anteil an strahlungsabsorbierenden Partikeln abnimmt. Ebenso nimmt die Strahlungsintensität mit zunehmendem Anteil an strahlungsabsorbierenden Partikeln und für einen gleichen Anteil an Streupartikeln ab.

Bei dem Bauelement wird auf Kosten der emittierten Strahlungsintensität eine homogenere Abstrahlcharakteristik aufgrund der Streupartikel sowie eine signifikant geringe Reflektivität hinsichtlich Fremdstrahlung von außen aufgrund der strahlungsabsorbierenden Partikel realisiert. Derartige Bauelemente können für Anwendungen, bei denen es nicht allein auf die absolute Strahlungsintensität ankommt, sondern bei denen insbesondere ein Kontrast in der Wahrnehmung des Bauelements bei Betrieb einerseits und bei Nichtbetrieb andererseits von Bedeutung ist, vorteilhaft sein.

In Figur 5 ist eine Draufsicht auf ein Bauelement dargestellt, bei dem drei Lumineszenzdiodenchips 1 in der Ausnehmung 9 angeordnet sind. Entsprechend weist das Gehäuse insgesamt sechs elektrische Anschlüsse 2,3 auf, nämlich drei erste elektrische Anschlüsse 2 und drei zweite elektrische Anschlüsse 3. Mittels Streupartikel in der Ausnehmung kann verhindert werden, dass die Emissionsflächen des Lumineszenzdiodenchips 1 als solche separat wahrnehmbar sind. Die Lumineszenzdiodenchips können gleichartig oder untereinander unterschiedlich ausgebildet sein.

Die Erfindung ist nicht durch die Beschreibung der Erfindung anhand der Ausführungsbeispiele auf diese beschränkt. Vielmehr umfasst die Erfindung jedes neue Merkmal sowie jede Kombination von Merkmalen, was insbesondere jede Kombination von Merkmalen in den Patentansprüchen beinhaltet, auch wenn dieses Merkmal oder diese Kombination selbst nicht explizit in den Patentansprüchen oder Ausführungsbeispielen angegeben ist. Neben Ruß gibt es eine Vielzahl weiterer Materialien, die grundsätzlich für die Verwendung als strahlungsabsorbierende Partikel in dem Bauelement geeignet sind.

## Patentansprüche

1. Optoelektronisches Bauelement, das eine Nutzstrahlung emittiert, mit einem Gehäuse, wobei das Gehäuse einen Gehäusegrundkörper (8) mit einem Grundkörpermaterial und einer Gehäusekavität und ein für die Nutzstrahlung durchlässiges Gehäusematerial (5) aufweist, und mit einem in der Gehäusekavität angeordneten Lumineszenzdiodenchip (1),
wobei sowohl das Gehäusematerial (5) als auch das Grundkörpermaterial zum Verringern ihrer Reflektivität gezielt mit strahlungsabsorbierenden Partikeln (61, 62) versetzt sind.

2. Optoelektronisches Bauelement gemäß Patentanspruch 1, **dadurch gekennzeichnet, dass** in der Gehäusekavität Streupartikel (16) zum Streuen der Nutzstrahlung angeordnet sind.

3. Optoelektronisches Bauelement gemäß einem der vorhergehenden Patentansprüche,
**dadurch gekennzeichnet, dass** Streupartikel (16) zum Streuen der Nutzstrahlung in dem für die Nutzstrahlung durchlässigen Gehäusematerial (5) enthalten sind.

4. Optoelektronisches Bauelement gemäß einem der vorhergehenden Patentansprüche,
**dadurch gekennzeichnet, dass**
das für die Nutzstrahlung durchlässige Gehäusematerial (5) und/oder das Grundkörpermaterial eine Gussmasse oder Pressmasse aufweist.

5. Optoelektronisches Bauelement gemäß einem der vorhergehenden Patentansprüche,
**dadurch gekennzeichnet, dass**
das für die Nutzstrahlung durchlässige Gehäusematerial (5) mindestens eines der Materialien aus der Gruppe bestehend aus Epoxidharz, Acrylat, Silikon, Thermoplast und Hybridmaterial mit mindestens einem dieser Materialien aufweist.

6. Optoelektronisches Bauelement gemäß einem der vorhergehenden Patentansprüche,
**dadurch gekennzeichnet, dass**
die strahlungsabsorbierenden Partikel (61, 62) des (5) Gehäusematerials und/oder des Grundkörpermaterials mindestens ein Element aus der Gruppe bestehend aus Ruß und Graphit aufweisen.

7. Optoelektronisches Bauelement gemäß Anspruch 6,
**dadurch gekennzeichnet, dass**
der Ruß ein Industrieruß mit kompakter Aggregatstruktur ist (LSCB, "low structure carbon black").

8. Optoelektronisches Bauelement gemäß einem der vorhergehenden Patentansprüche,
**dadurch gekennzeichnet, dass**
die strahlungsabsorbierenden Partikel (61, 62) des Gehäusematerials (5) und/oder des Grundkörpermaterials einen durchschnittlichen Partikeldurchmesser von kleiner als oder gleich 100 nm aufweisen.

9. Optoelektronisches Bauelement gemäß einem der vorhergehenden Patentansprüche,
**dadurch gekennzeichnet, dass**
der Absorptionskoeffizient der strahlungsabsorbierenden Partikel (61, 62) des Gehäusematerials (5) und/oder des Grundkörpermaterials im gesamten Spektrum der Nutzstrahlung um weniger als 10 % variiert.

10. Optoelektronisches Bauelement gemäß einem der vorhergehenden Patentansprüche,
**dadurch gekennzeichnet, dass**
die Gehäusekavität zumindest teilweise mit dem für die Nutzstrahlung durchlässigen Gehäusematerial (5) gefüllt ist.

11. Optoelektronisches Bauelement gemäß einem der vorhergehenden Patentansprüche,
**dadurch gekennzeichnet, dass**
der Lumineszenzdiodenchip (1) mittels des für die Nutzstrahlung durchlässigen Gehäusematerials (5) umkapselt oder umformt ist.

12. Optoelektronisches Bauelement gemäß einem der vorhergehenden Patentansprüche,
**dadurch gekennzeichnet, dass**
das für die Nutzstrahlung durchlässige Gehäusematerial (5) zumindest teilweise auf einer Außenfläche des Gehäusegrundkörpers (8) aufgebracht ist.

13. Verfahren zum Herstellen eines eine Nutzstrahlung emittierenden optoelektronischen Bauelements, mit den Schritten:
- Fertigen oder Bereitstellen eines Gehäusegrundkörpers (8) mit einer Gehäusekavität und mit einem Grundkörpermaterial, das gezielt mit strahlungsabsorbierenden Partikeln versetzt ist,
- Bereitstellen mindestens eines Lumineszenzdiodenchips (1),
- Bereitstellen eines für die Nutzstrahlung durchlässigen Materials, das gezielt mit strahlungsabsorbierenden Partikeln versetzt ist,
- Montieren des Lumineszenzdiodenchips (1) in der Gehäusekavität, und
- Anordnen des für die Nutzstrahlung durchlässigen Materials in einem Strahlengang der von dem Lumineszenzdiodenchip (1) bei dessen Betrieb zu emittierenden elektromagnetischen Strahlung.

14. Verfahren gemäß Anspruch 13,
bei dem ein Bauelement bereitgestellt wird, das den Lumineszenzdiodenchip (1) und den Gehäusegrundkörper(8) enthält und zumindest ein Teil der für die Nutzstrahlung durchlässigen Masse auf eine Außenfläche des Gehäuses aufgebracht wird.

15. Verfahren gemäß Anspruch 14,
bei dem zumindest ein Teil des für die Nutzstrahlung durchlässigen Materials vor dem Aufbringen auf der Außenfläche in Form einer vorgefertigten Materialschicht bereitgestellt wird.

## Claims

1. Optoelectronic component which emits a useful radiation, comprising a housing, wherein the housing has a housing basic body (8) comprising a basic body material and a housing cavity and comprises a housing material (5) which is transmissive to the useful radiation, and comprising a luminescence diode chip (1) arranged in the housing cavity,
wherein both the housing material (5) and the basic body material are admixed with radiation-absorbing particles (61, 62) in a targeted manner in order to reduce their reflectivity.

2. Optoelectronic component according to Claim 1,
**characterized in that**
scattering particles (16) for scattering the useful radiation are arranged in the housing cavity.

3. Optoelectronic component according to one of the preceding patent claims,
**characterized in that**
scattering particles (16) for scattering the useful radiation are contained in the housing material (5) which is transmissive to the useful radiation.

4. Optoelectronic component according to one of the preceding patent claims,
**characterized in that**
the housing material (5) which is transmissive to the useful radiation and/or the basic body material have/has a casting composition or moulding composition.

5. Optoelectronic component according to one of the preceding patent claims,
**characterized in that**
the housing material (5) which is transmissive to the useful radiation has at least one of the materials from the group comprising epoxy resin, acrylate, silicone, thermoplastic and hybrid material with at least one of said materials.

6. Optoelectronic component according to one of the preceding patent claims,
**characterized in that**
the radiation-absorbing particles (61, 62) of the housing material (5) and/or of the basic body material comprise at least one element from the group consisting of carbon black and graphite.

7. Optoelectronic component according to Claim 6,
**characterized in that**
the carbon black is an industrial carbon black with a compact aggregate structure (LSCB, "low structure carbon black").

8. Optoelectronic component according to one of the preceding patent claims,
**characterized in that**
the radiation-absorbing particles (61, 62) of the housing material (5) and/or of the basic body material have an average particle diameter of less than or equal to 100 nm.

9. Optoelectronic component according to one of the preceding patent claims,
**characterized in that**
the absorption coefficient of the radiation-absorbing particles (61, 62) of the housing material (5) and/or of the basic body material varies by less than 10% in the entire spectrum of the useful radiation.

10. Optoelectronic component according to one of the preceding patent claims,
**characterized in that**
the housing cavity is at least partly filled with the housing material (5) which is transmissive to the useful radiation.

11. Optoelectronic component according to one of the preceding patent claims,
**characterized in that**
the luminescence diode chip (1) is encapsulated or surrounded by moulding by means of the housing material (5) which is transmissive to the useful radiation.

12. Optoelectronic component according to one of the preceding patent claims,
**characterized in that**
the housing material (5) which is transmissive to the useful radiation is at least partially applied on an exterior area of the housing basic body (8).

13. Method for producing an optoelectronic component which emits a useful radiation, comprising the steps of:
- producing or providing a housing basic body (8) having a housing cavity and comprising a basic body material which is admixed with radiation-absorbing particles in a targeted manner,
- providing at least one luminescence diode chip (1) ,
- providing a material which is transmissive to the useful radiation and which is admixed with radiation-absorbing particles in a targeted manner,
- mounting the luminescence diode chip (1) in the housing cavity, and
- arranging the material which is transmissive to the useful radiation in a beam path of the electromagnetic radiation emitted by the luminescence diode chip (1) during the operation thereof.

14. Method according to Claim 13,
in which a component is provided which contains the luminescence diode chip (1) and the housing basic body (8) and at least a part of the composition which is transmissive to the useful radiation is applied to the exterior area of the housing.

15. Method according to Claim 14,
in which at least a part of the material which is transmissive to the useful radiation is provided prior to application on the exterior area in the form of a prefabricated material layer.

## Revendications

1. Composant optoélectronique émettant un rayonnement utile, avec un boîtier, le boîtier comportant une base (8) de boîtier avec un matériau de la base et une cavité de boîtier et un matériau (5) de boîtier transparent au rayonnement utile, et avec une puce de diode luminescente (1) disposée dans la cavité du boîtier,
dans lequel non seulement le matériau (5) de boîtier mais aussi le matériau de la base sont additionnés de manière ciblée de particules (61, 62) absorbant le rayonnement pour réduire leur réflectivité.

2. Composant optoélectronique selon la revendication 1, **caractérisé en ce que** des particules diffusantes (16) sont disposées dans la cavité du boîtier pour la diffusion du rayonnement utile.

3. Composant optoélectronique selon une des revendications précédentes,
**caractérisé en ce que** des particules diffusantes (16) pour la diffusion du rayonnement utile sont contenues dans le matériau (5) du boîtier transparent au rayonnement utile.

4. Composant optoélectronique selon une des revendications précédentes,
**caractérisé en ce que** le matériau (5) du boîtier transparent au rayonnement utile et/ou le matériau de la base comportent une matière moulée ou une matière pressée.

5. Composant optoélectronique selon une des revendications précédentes,
**caractérisé en ce que** le matériau (5) du boîtier transparent au rayonnement utile, comporte au moins un des matériaux du groupe constitué de résine époxy, d'acrylate, de silicone, de thermoplastique et de matériau hybride avec au moins un de ces matériaux.

6. Composant optoélectronique selon une des revendications précédentes,
**caractérisé en ce que** les particules (61, 62) absorbant le rayonnement du matériau (5) du boîtier et/ou du matériau de la base comportent au moins un élément du groupe constitué du noir de carbone et du graphite.

7. Composant optoélectronique selon la revendication 6,
**caractérisé en ce que** le noir de carbone est un noir de carbone industriel avec une structure compacte d'agrégats (LSCB, "low structure carbon black").

8. Composant optoélectronique selon une des revendications précédentes,
**caractérisé en ce que** les particules (61, 62) absorbant le rayonnement du matériau (5) du boîtier et/ou du matériau de la base comportent un diamètre moyen de particules inférieur ou égal à 100 nm.

9. Composant optoélectronique selon une des revendications précédentes,
**caractérisé en ce que** le coefficient d'absorption des particules (61, 62) absorbant le rayonnement du matériau (5) du boîtier et/ou du matériau de la base varie de moins de 10% sur l'ensemble du spectre du rayonnement utile.

10. Composant optoélectronique selon une des revendications précédentes,
**caractérisé en ce que** la cavité du boîtier est remplie au moins partiellement par le matériau (5) du boîtier transparent au rayonnement utile.

11. Composant optoélectronique selon une des revendications précédentes,
**caractérisé en ce que** la puce de diode luminescente (1) est encapsulée ou protégée par formage dans le matériau (5) du boîtier transparent au rayonnement utile.

12. Composant optoélectronique selon une des revendications précédentes,
**caractérisé en ce que** le matériau (5) du boîtier transparent au rayonnement utile est appliqué au moins partiellement sur une surface extérieure de la base (8) du boîtier.

13. Procédé pour la fabrication d'un composant optoélectronique émettant un rayonnement utile, avec les étapes suivantes :
- fabrication ou préparation d'une base (8) de boîtier avec une cavité de boîtier et avec un matériau de la base additionné de manière ciblée de particules absorbant le rayonnement
- préparation d'au moins une puce de diode luminescente (1),
- préparation d'un matériau transparent au rayonnement utile, qui est additionné de manière ciblée de particules absorbant le rayonnement
- montage de la puce de diode luminescente (1) dans la cavité du boîtier, et
- disposer le matériau transparent au rayonnement utile sur un chemin optique du rayonnement électromagnétique émis par la puce de diode luminescente (1) lors de son fonctionnement.

14. Procédé selon la revendication 13,
dans lequel on prépare un composant contenant la puce de diode luminescente (1) et la base (8) de boîtier et dans lequel on applique une partie au moins de la matière transparente au rayonnement utile sur une surface extérieure du boîtier.

15. Procédé selon la revendication 14,
dans lequel on prépare une partie au moins du matériau transparent au rayonnement utile avant l'application sur la surface extérieure sous la forme d'une couche de matériau préfabriquée.
